# FASCICULE DE BREVET EUROPEEN

(11) **EP 2 691 958 B1**
(45) Date de publication et mention de la délivrance du brevet: **27.05.2020**
(21) Numéro de dépôt: 12713131.6
(22) Date de dépôt: 02.04.2012
(51) Int. Cl.: G11C 11/22, G11C 11/56

(54) **PROCEDE DE MISE EN OEUVRE D'UNE JONCTION TUNNEL FERROELECTRIQUE, DISPOSITIF COMPRENANT UNE JONCTION TUNNEL FERROELECTRIQUE ET UTILISATION D'UN TEL DISPOSITIF**
VERFAHREN ZUR IMPLEMENTIERUNG EINES FERROELEKTRISCHEN TUNNELÜBERGANGS, VORRICHTUNG MIT EINEM FERROELEKTRISCHEN TUNNELÜBERGANG UND VERWENDUNG EINER SOLCHEN VORRICHTUNG
METHOD OF IMPLEMENTING A FERROELECTRIC TUNNEL JUNCTION, DEVICE COMPRISING A FERROELECTRIC TUNNEL JUNCTION AND USE OF SUCH A DEVICE

(30) Priorité: 31.03.2011 FR 1100967
(43) Date de publication de la demande: 05.02.2014
(73) Titulaire: THALES, 92200 Neuilly-sur-Seine (FR); Centre National de la Recherche Scientifique (C.N.R.S.), 75016 Paris (FR); Université Paris-Saclay, 91190 Saint-Aubin (FR)
(72) Inventeur: BIBES, Manuel, F-75013 Paris (FR); GARCIA, Vincent, F-75015 Paris (FR); BARTHELEMY, Agnès, F-91640 Janvry (FR); BOUZEHOUANE, Karim, F-91640 Janvry (FR); FUSIL, Stéphane, F-91620 La Ville du Bois (FR)
(74) Mandataire: Lavoix
(86) Numéro de dépôt international: PCT/EP2012/055970
(87) Numéro de publication internationale: WO 2012/131093

(56) Documents cités:
- US-A- 5 541 422
- US-A- 5 751 625
- US-A1- 2003 112 650

## Description

La présente invention concerne un procédé de mise en œuvre d'une jonction tunnel ferroélectrique, ladite jonction appartenant au domaine des hétérostructures de couches minces pouvant notamment être utilisées comme éléments constituant une mémoire non-volatile à accès aléatoire.

Dans les dispositifs microélectroniques actuels, le stockage non-volatil de l'information est principalement assuré par des disques durs magnétiques et des mémoires non-volatiles à accès aléatoires (NVRAM).

Ainsi, dans ces dispositifs, l'information est codée sous forme binaire de sorte que les mémoires stockent des « 0 » et des « 1 » et est traitée par des transistors dans des états passants, dits « ON » ou bloqués, dits « OFF ».

Les disques durs magnétiques présentent l'avantage d'être peu coûteux. Toutefois, ils sont lents et fragiles.

Le marché des NVRAM est dominé par les mémoires Flash. Les mémoires Flash possèdent des temps d'écriture très longs (de l'ordre de la milliseconde) et une endurance limitée (de l'ordre de 10⁵ cycles). Les NVRAM peuvent également être des mémoires à changement de phase (PCRAM) ou des mémoires magnétiques non-volatiles à accès aléatoire (MRAM).

Par exemple, le document US 2003/112650 divulgue un élément mémoire ferroélectrique non-volatile.

Ces mémoires possèdent une endurance accrue et des temps de lecture plus courts, mais leur consommation en écriture est actuellement trop élevée pour leur permettre de remplacer à grande échelle les mémoires Flash.

Aucune des différentes technologies de NVRAM actuelles n'apparaît satisfaisante au vu des inconvénients mentionnés ci-dessus.

Afin de résoudre les problèmes mentionnés ci-dessus, il a été proposé des dispositifs à deux terminaux électriques présentant un effet d'électro-résistance, à base de TiO₂ par exemple.

Cependant, les différents états de résistance correspondent à différentes distributions spatiales d'ions, d'atomes ou de défauts comme les lacunes d'oxygène. Leur fonctionnement repose donc sur l'effet d'électro-migration d'ions ou d'atomes, ce qui implique des températures de fonctionnement élevées, une fragilité potentielle des dispositifs, et une vitesse de fonctionnement mal maîtrisée puisque liée à la mobilité des ions ou des atomes.

Comme mentionné ci-dessus, les technologies de stockage d'information sont loin d'être optimales, et possèdent selon la technologie utilisée des temps d'écriture longs et/ou une endurance limitée et/ou une consommation en écriture élevée et/ou une robustesse limitée.

De plus, si ces systèmes fonctionnent actuellement selon une logique binaire, de nombreuses études envisagent pour les années à venir le traitement de l'information sous forme analogique.

De nouveaux développements ont donc été réalisés, parmi ceux-ci un dispositif de mémoire non-volatile fondé sur une jonction tunnel ferroélectrique, constitué d'un ensemble composé de deux couches, formant chacune un élément conducteur de type électrode et séparées par une fine couche constituée d'un isolant ferroélectrique jouant le rôle de barrière tunnel.

Ainsi, en dessous de la température de Curie de la barrière ferroélectrique, il est possible d'induire dans l'élément ferroélectrique une polarisation rémanente macroscopique, pouvant être orientée selon les deux sens d'une même direction, le sens de la polarisation dépendant du signe de la tension appliquée entre les électrodes.

Selon la direction de la polarisation ferroélectrique, le courant tunnel à travers la barrière ferroélectrique possède des valeurs différentes, ce qui est communément appelé « effet d'électro-résistance tunnel ». On peut qualifier le comportement de la jonction tunnel ferroélectrique par le rapport des résistances tunnel correspondant à des polarisations différentes, par exemple opposées, ou rapport dit «OFF-ON».

Théoriquement, le rapport des résistances tunnel peut atteindre des valeurs de 100 à 1000 voire plus.

De plus, ces valeurs sont reproductibles d'un dispositif à l'autre et ceci pour des milliers de cycles d'écriture.

Le concept de jonction tunnel ferroélectrique, appelé « polar switch » a été décrit en 1971 par L. Esaki et al [IBM Techn. Disclos. Bull. 13, 2161 (1971)]. De même, de tels dispositifs sont décrits dans les brevets suivants US 5,541,422, US2006/0145225A1 et US 7,759,713.

Les dispositifs de mémoire non-volatile à base de jonctions tunnel ferroélectriques, tels que décrits ci-dessus, utilisent la direction macroscopique de la polarisation ferroélectrique dans la barrière tunnel pour stocker l'information.

Ces dispositifs présentent l'inconvénient de n'encoder que des informations binaires ou, dans certains cas, des informations discrètes, mais pas d'informations analogiques.

Il est à noter qu'une jonction tunnel ferroélectrique diffère d'une capacitance ferroélectrique, telle que par exemple décrite dans le document US 5 751 625, dans laquelle l'information est encodée, non pas par la direction macroscopique de la polarisation électrique, mais par la charge stockée par la capacitance.

L'invention a pour but de proposer un procédé de mise en œuvre d'une jonction tunnel ferroélectrique permettant d'écrire de l'information sur un dispositif de stockage sous forme binaire ou sous forme analogique.

A cet effet, l'invention a pour objet, conformément aux revendications, un procédé de mise en œuvre d'une jonction tunnel ferroélectrique, un dispositif comprenant une jonction tunnel ferroélectrique mise en œuvre selon ce procédé, et différentes utilisations de ce dispositif.

L'invention sera mieux comprise à la lecture de la description qui va suivre, donnée uniquement à titre d'exemple et faite en se référant aux dessins annexés sur lesquels :
- la Figure 1 est une vue en coupe transversale d'une jonction tunnel ferroélectrique ;
- les Figures 2 à 5 représentent différents cycles d'hystérésis représentant le comportement de la polarisation d'un matériau ferroélectrique en fonction d'une tension appliquée, chaque cycle d'hystérésis étant associé à une représentation schématique en vue de dessus de la configuration en domaines mettant en évidence la polarisation dans l'élément ferroélectrique.

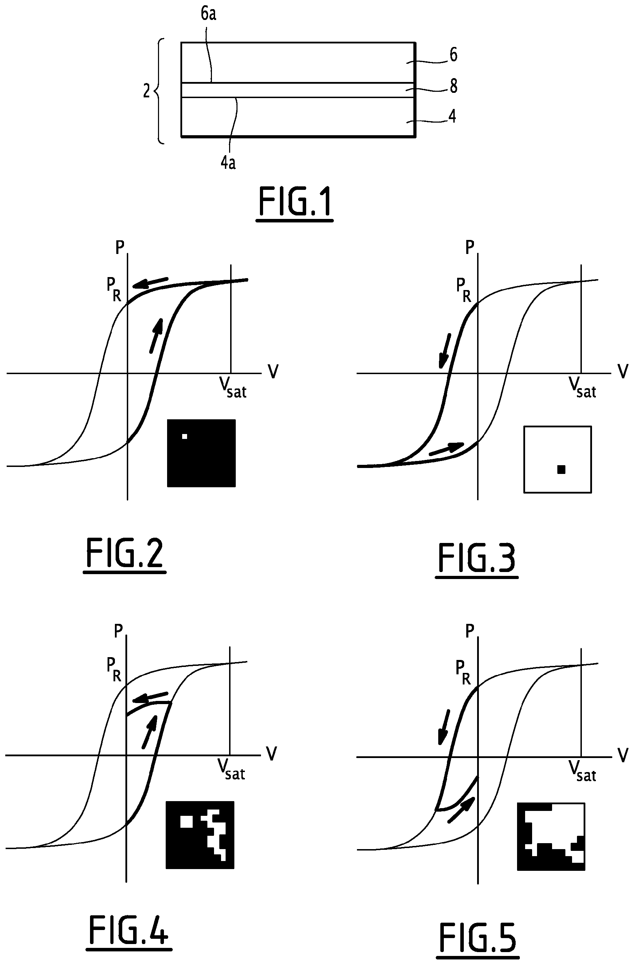

Le dispositif représenté à la Figure 1 comporte un ensemble 2 composé de deux couches minces 4 et 6 formant chacune un élément conducteur de type électrode, de manière à former respectivement une « électrode inférieure » et une « électrode supérieure », lesdites couches 4 et 6 étant séparées par une couche mince 8 formée d'un matériau ferroélectrique formant un élément ferroélectrique.

La couche ferroélectrique 8 peut être constituée d'un matériau organique de type polymère, tel que l'acide croconique, le PVDF (fluorure de polyvinylidène), le PVPS (difluorure de polyvinilidene) ou leurs copolymères ; d'un matériau inorganique à structure pérovskite, tel que (Ba,Sr)TiO₃, Pb(Zr,Ti)O₃, Bi(Fe,Mn)O₃, Sr_{0.8}Bi₂₂Ta₂O₉, dit « SBT », SrBi₂Nb₂O₉ dit « SBN », etc, ces matériaux pouvant être éventuellement soumis à une contrainte biaxiale en tension ou en compression ; ou d'un oxyde binaire, tel que BaO ou SrO, soumis à une contrainte biaxiale en tension ou en compression, cette liste étant non exhaustive.

De préférence, la couche ferroélectrique 8 peut posséder une épaisseur comprise entre 0.1 et 10 nm.

De préférence, la couche ferroélectrique 8 peut générer une barrière de potentiel positive ou négative allant de 50 millielectronvolts (meV) à quelques électronvolts (eV) par rapport au niveau de Fermi des électrodes supérieure et inférieure formées par les couches minces 4 et 6, la hauteur de la barrière de potentiel étant notamment liée à la nature de la couche ferroélectrique 8 et à la structure électronique du matériau la constituant.

Les électrodes supérieure et inférieure, formées par les couches minces 4 et 6 peuvent être réalisés de manière non exhaustive à l'aide des matériaux suivants : SrRuO₃, (La,Sr)MnO₃, CaRuO₃, SrVO₃, (La,Sr)CoO₃, LaNiO₃, ITO (oxyde d'indium-étain), Pt ou ses alliages, Pd ou ses alliages Ir ou ses oxydes (IrOₓ) ou ses alliages, Ru ou ses oxydes (RuOₓ) ou ses alliages.

Les électrodes supérieure et inférieure peuvent être constituées par le même matériau ou, en variante, par des matériaux différents.

De préférence, les couches minces 4 et 6 peuvent posséder une épaisseur comprise entre 0,5 et 200 nm.

De préférence, la surface supérieure 4a de l'électrode inférieure 4 et la surface inférieure 6a de l'électrode supérieure 6, entre lesquelles s'étend la couche ferroélectrique 8, s'étendent parallèlement.

De façon classique, le dispositif représenté à la Figure 1 peut être élaboré par une ou plusieurs techniques de croissance combinées, telles que l'ablation laser puisée, la pulvérisation cathodique, la CVD, l'évaporation, l'épitaxie par jet moléculaire ou autres.

Le dispositif de la Figure 1 constitue une hétérostructure de couches minces dans laquelle la couche ferroélectrique 8 est utilisée comme « barrière tunnel », ladite couche 8 étant disposée entre les deux couches 4 et 6 conductrices utilisées comme électrode. Cette hétérostructure est de façon connue appelée « jonction tunnel ferroélectrique ».

Comme nous le décrirons ultérieurement, lors de la mise en œuvre de la jonction tunnel selon le procédé de l'invention, la barrière tunnel constituée par la couche ferroélectrique 8 possède une structure en domaines, les domaines correspondant à des zones de la couche dans lesquelles la polarisation est orientée dans un sens unique d'une direction unique.

Par la suite, nous considérerons seulement la valeur de la projection de la polarisation, qui selon le cas, s'étend selon une direction normale à la surface supérieure 4a de l'électrode inférieure 4 ou selon une direction normale à la surface inférieure 6a de l'électrode supérieure 6.

Comme on va le voir par la suite, la structure en domaines est contrôlée par la tension électrique appliquée aux électrodes.

Comme représenté aux Figures 2 à 5, l'invention propose d'exploiter la structure en domaines de la barrière tunnel. Les cycles d'hystérésis représentés montrent la polarisation P en fonction de la tension V appliquée entre les électrodes pour une barrière ferroélectrique donnée, chaque courbe en trait épais décrivant la variation de la polarisation en fonction de la tension appliquée, la structure en domaines associée à l'état de polarisation atteint après chaque application de tension étant représentée schématiquement en bas à droite de chaque Figure. La représentation en trait fin correspond au cycle saturé.

En ce qui concerne la représentation de la configuration en domaines, il a été choisi de se placer dans le cas simple où la polarisation est orientée selon deux sens opposés d'une même direction, les zones polarisées étant représentées en blanc ou en noir sur ces schémas selon le sens de la polarisation.

Comme on va le voir deux modes de fonctionnement de la jonction tunnel peuvent être envisagés.

Un premier mode de fonctionnement de type « binaire » est représenté aux Figures 2 et 3. Dans ce mode, la barrière tunnel ne possède qu'un seul domaine ou majoritairement qu'un seul domaine, de manière à ce que la barrière tunnel ne possède qu'un domaine majoritaire ou qu'un ensemble de domaines majoritaires correspondant à plus de 50% de la surface de la barrière, et de préférence à plus de 80% de la surface de la barrière, et encore mieux à plus de 95% de la surface de la barrière.

Ce qui signifie qu'en appliquant une tension égale ou supérieure à une tension de saturation nommée Vₛₐₜ, la polarisation rémanente est maximale et principalement orientée selon une direction normale à la surface supérieure 4a de l'électrode inférieure 4 ou à la surface inférieure 6a de l'électrode supérieure 6. Cette polarisation rémanente maximale est notée Pr sur les Figures.

Le sens de cette polarisation est déterminé par le signe de la tension choisie.

A la Figure 2, est représentée l'évolution de la polarisation ferroélectrique lors de l'application d'une tension positive égale ou supérieure à la tension de saturation V_{sat.}

De même, à la Figure 3 est représentée l'évolution de la polarisation ferroélectrique lors de l'application d'une tension négative dont la valeur absolue est égale ou supérieure à la valeur absolue de la tension de saturation V_{sat.}

Ainsi, les états représentés aux Figures 2 et 3 correspondent à des états dits quasi-saturés dont la polarisation s'étend pour chacun selon des sens opposés. De tels états correspondent à deux états logiques différents dits de type « ON » et « OFF ».

Un second mode de fonctionnement de type « analogique » est représenté aux Figures 4 et 5. Dans ce mode, la barrière tunnel possède plusieurs domaines répartis aléatoirement dans la couche ferroélectrique 8, de manière à ce qu'une partie des domaines possède une polarisation rémanente orientée selon une direction normale à la surface supérieure 4a de l'électrode inférieure 4 et l'autre partie des domaines possède une polarisation rémanente orientée selon une direction normale à la surface inférieure 6a de l'électrode supérieure 6. Dans le cas représenté, ces deux directions sont identiques, mais les sens des deux polarisations doivent être opposés.

Ce mode de fonctionnement est obtenu en appliquant en valeur absolue une tension inférieure à celle de la tension de saturation V_{sat.} Une multitude de configuration de la structure en domaines est alors possible, la répartition des domaines et leurs proportions étant fonction de la valeur de tension choisie.

A la Figure 4, est représentée l'évolution de la polarisation ferroélectrique lors de l'application d'une tension positive inférieure à la tension de saturation Vₛₐₜ.

De même, à la Figure 5 est représentée l'évolution de la polarisation ferroélectrique lors de l'application d'une tension négative, dont la valeur absolue est inférieure à celle de la tension de saturation Vₛₐₜ.

On notera que l'utilisation d'une couche ferroélectrique mince permet généralement d'obtenir un cycle d'hystérésis incliné et non carré comme celui obtenu lors de l'utilisation d'une couche plus épaisse. Ce type de cycle permet, quelle que soit la tension appliquée, de stabiliser les états de polarisation intermédiaires de la structure en domaines.

Il sera par la suite admis que les différents domaines de la structure conduisent le courant en parallèle. Ainsi, la résistance de la jonction tunnel ferroélectrique dépend de la taille et de la proportion relative de domaines et de la polarisation dans le domaine. Ainsi, il est possible d'obtenir une résistance de la jonction tunnel ferroélectrique dont la valeur évolue de façon continue.

L'arrêt de la tension appliquée aux électrodes permet d'obtenir une stabilisation de la structure en domaines choisie, la structure en domaines et donc la résistance évoluant lorsqu'une nouvelle tension de valeur différente est appliquée.

La présente invention propose d'exploiter la structure en domaines de la couche ferroélectrique 8 composant la barrière tunnel pour permettre un fonctionnement binaire ou analogique.

Ainsi grâce au procédé de l'invention, la jonction tunnel ferroélectrique peut être utilisée notamment comme élément mémoire non-volatile utilisant la direction macroscopique de la polarisation ferroélectrique dans la barrière tunnel pour stocker de l'information.

Dans le cas où l'on souhaite un fonctionnement binaire, une tension, dont la valeur absolue est supérieure ou égale à celle de la tension de saturation Vₛₐₜ, est appliquée de manière à ce que la barrière tunnel ne possède qu'un seul domaine ou majoritairement qu'un seul domaine, de manière à ce que la barrière tunnel ne possède qu'un domaine majoritaire ou qu'un ensemble de domaines majoritaires, la polarisation rémanente étant alors maximale et principalement orientée selon une direction normale aux surfaces 4a ou 6a des électrodes.

Dans le cas où l'on souhaite un fonctionnement analogique, une ou plusieurs tension(s) dite(s) « intermédiaire(s) », c'est-à-dire dire dont la valeur absolue est inférieure à celle de la tension de saturation Vₛₐₜ, est (sont) appliquée(s). La distribution spatiale des domaines et leurs proportions relatives, dans laquelle la polarisation pointe vers l'une ou l'autre des électrodes, dépendent alors de la ou des valeurs de tension choisie(s).

Lorsque l'on souhaite lire les informations contenues dans les éléments mémoire non-volatile, lesdites informations étant écrites comme mentionnées précédemment, une tension de lecture nettement plus faible que la tension d'écriture est appliquée afin de ne pas détruire l'information stockée. Le dispositif de lecture récupère alors la valeur de la résistance dépendant de la structure en domaines précédemment créée.

L'invention permet également d'organiser les jonctions tunnel ferroélectriques selon des matrices bidimensionnelles ou tridimensionnelles pour réaliser notamment des éléments mémoires binaires ou analogiques de grande capacité, ou des réseaux de connecteurs de résistance variable non-volatile .

Le comportement de la jonction tunnel ferroélectrique peut être défini par le rapport maximal des résistances obtenues en mode lecture, chaque résistance étant obtenue pour une direction de polarisation différente. De préférence, ce rapport maximal est obtenu pour des directions de polarisation identiques et des sens de polarisation opposés, ce rapport est également appelé rapport « OFF-ON».

Des essais de laboratoire prometteurs ont mis en évidence des rapports « OFF-ON» supérieur à 100. Ces essais se sont révélés reproductibles sur des dizaines de dispositifs et des milliers de cycles d'écriture.

Par analogie avec les performances des mémoires ferroélectriques à accès aléatoires FeRAM, des fréquences de fonctionnement très élevées, de l'ordre du GigaHertz sont attendues, avec une endurance supérieure à 10¹⁴ cycles et une énergie d'écriture inférieure à 10⁻¹⁴ J/bit une fois les composants optimisés.

Contrairement aux procédés de mise en œuvre des jonctions tunnel de l'art antérieur, dont la modulation de la hauteur de la barrière tunnel est seulement dépendante de la polarisation ferroélectrique, le procédé de mise en œuvre selon l'invention envisage plusieurs autres mécanismes physiques pour contrôler l'effet d'électro-résistance.

Ainsi, la valeur de la résistance d'un domaine est liée à la direction et au sens de la polarisation et à l'amplitude de la polarisation ferroélectrique. Ces propriétés influencent notamment l'épaisseur et la hauteur de la barrière tunnel constituée par la couche ferroélectrique 8.

De même, ces propriétés dépendent de la densité d'états au niveau de l'interface présente entre la barrière tunnel et l'électrode inférieure 4 et de la densité d'états au niveau de l'interface présente entre la barrière tunnel et l'électrode supérieure 6, ainsi que de la symétrie des fonctions d'ondes électroniques participant au courant tunnel et du couplage des fonctions d'ondes électroniques participant au courant tunnel avec les fonctions d'ondes électroniques présentes dans les électrodes.

De nombreuses applications industrielles du procédé selon l'invention peuvent être envisagées dans lesquelles la jonction tunnel est contrôlée électriquement, telle que la réalisation d'un élément mémoire non-volatile binaire dans lequel l'information est écrite par application d'une tension positive ou négative, les valeurs absolues des tensions appliquées lors de l'écriture étant égales ou supérieures à la valeur absolue de la tension de saturation.

Egalement, la jonction tunnel peut être utilisée comme élément mémoire non-volatile analogique dans lequel l'information est écrite par application d'une tension ou d'une succession de tension variable, positive ou négative, de valeur absolue inférieure à la valeur absolue de la tension de saturation.

Dans ces exemples, lors de la lecture de l'information, la résistance est mesurée sous l'application d'une tension nettement inférieure à la tension d'écrite.

Egalement, la jonction tunnel peut être utilisée comme élément de circuit logique ou comme micro-interrupteur, contrôlable par application d'une tension positive ou négative, les valeurs absolues des tensions appliquées étant égales ou supérieures à la valeur absolue de la tension de saturation.

Egalement, la jonction tunnel peut être utilisée comme connecteur de résistance variable non-volatile dans lequel l'information est écrite par application d'une tension variable, positive ou négative.

## Revendications

1. Procédé d'utilisation d'un dispositif comme élément mémoire non-volatile analogique, ledit dispositif comprenant une jonction tunnel ferroélectrique, ladite jonction comprenant deux couches (4, 6) formant chacune un élément conducteur de type électrode et séparées seulement par une unique couche constituée d'un seul ferroélectrique formant un élément ferroélectrique (8) ayant le rôle de barrière tunnel, l'élément ferroélectrique (8) possédant une épaisseur comprise entre 0,1 et 10 nm, et l'élément ferroélectrique (8) possédant une structure en domaines, lesdits domaines correspondant à des zones de l'élément ferroélectrique dans lesquelles la polarisation est orientée dans un sens unique d'une direction unique, **caractérisée en ce que** une information est écrite sous forme analogique dans ledit dispositif par application d'une tension ou d'une succession de tensions variables, de valeur absolue inférieure à la valeur absolue d'une tension de saturation, l'élément ferroélectrique possédant alors une pluralité de domaines distincts, dont la distribution spatiale et les proportions sont contrôlées par la valeur de tension choisie, la tension de saturation étant définie comme la tension au-delà de laquelle l'élément ferroélectrique ne possède majoritairement qu'un seul domaine.

2. Procédé selon la revendication 1, **caractérisé en ce que** l'élément ferroélectrique (8) génère une barrière de potentiel positive ou négative allant de 50 milliélectronvolts à quelques électronvolts par rapport au niveau de Fermi des couches (4, 6) formant chacune un élément conducteur.

3. Procédé selon quelconque des revendications 1 et 2, **caractérisé en ce que** les couches (4, 6) formant chacune un élément conducteur possèdent une épaisseur comprise entre 0,5 et 200 nm.

4. Procédé selon quelconque des revendications 1 à 3, **caractérisé en ce que**, l'information stockée dans la jonction tunnel est lue par application d'une tension de lecture inférieure en valeur absolue à la valeur absolue de la tension ayant permis de stocker l'information dans ladite jonction.

## Patentansprüche

1. Verfahren zum Verwenden einer Vorrichtung als analoges nicht flüchtiges Speicherelement, wobei die Vorrichtung einen ferroelektrischen Tunnelübergang umfasst, wobei der Übergang zwei Schichten (4, 6) aufweist, die jeweils ein leitendes Element als Elektrode bilden und nur durch eine einzige Schicht getrennt sind, die aus einem einzigen Ferroelektrikum besteht, das ein als Tunnelsperrschicht dienendes ferroelektrisches Element (8) bildet, wobei das ferroelektrische Element (8) eine Dicke zwischen 0,1 und 10 nm besitzt, wobei das ferroelektrische Element (8) eine Domänenstruktur besitzt und die Domänen Zonen des ferroelektrischen Elementes entsprechen, in denen die Polarisation in einer einzigen Richtung gleichsinnig orientiert ist, **dadurch gekennzeichnet, dass** eine Information in analoger Form in die Vorrichtung durch Aufbringen einer Spannung oder einer Folge von variablen Spannungen mit einem Absolutwert kleiner als dem Absolutwert einer Sättigungsspannung eingeschrieben wird, wobei das ferroelektrische Element eine Mehrzahl von getrennten Domänen besitzt, deren räumliche Verteilung und Ausmaße durch den gewählten Spannungswert gesteuert werden, wobei die Sättigungsspannung als die Spannung definiert wird, über der das ferroelektrische Element hauptsächlich nur eine einzige Domäne besitzt.

2. Verfahren nach Anspruch 1, **dadurch gekennzeichnet, dass** das ferroelektrische Element (8) eine Sperrschicht positiven oder negativen Potenzials zwischen 50 Millielektronenvolt bis zu einigen Elektronenvolts in Bezug auf das Fermi-Niveau der Schichten (4, 6) erzeugt, die jeweils ein leitendes Element bilden.

3. Verfahren nach einem beliebigen der Ansprüche 1 und 2, **dadurch gekennzeichnet, dass** die Schichten (4, 6), die jeweils ein leitendes Element bilden, eine Dicke zwischen 0,5 und 200 nm besitzen.

4. Verfahren nach einem beliebigen der Ansprüche 1 bis 3, **dadurch gekennzeichnet, dass** die in dem Tunnelübergang gespeicherte Information durch Aufbringen einer Lesespannung mit einem Absolutwert kleiner als dem Absolutwert der Spannung, die das Speichern der Information in dem Übergang ermöglicht hat, ausgelesen wird.

## Claims

1. A method of use of a device as an analogous non-volatile memory cell, said device comprising a ferroelectric tunnel junction, said junction comprising two layers (4, 6) each forming an electrode-type conductive element, and separated only by a single layer (8) made of a single ferroelectric material forming a ferroelectric element (8) acting as the tunnel barrier, the ferroelectric element (8) having a thickness comprised between 0.1 and 10 nm, and the ferroelectric element (8) possessing a domain structure, said domains corresponding to regions of the ferroelectric element the polarization of which is oriented along one single way of a single direction,
**characterized in that** a piece of information is analogously written in said device by applying a voltage or a series of variable voltages, with an absolute value lower than the absolute value of a saturation voltage, the ferroelectric element then possessing a plurality of distinct domains, whose spatial distribution and proportions are controlled by the value of the voltage chosen, the saturation tension being defined as the voltage beyond which the ferroelectric element possesses mainly only one domain.

2. The method according to claim 1, **characterized in that** the ferroelectric element (8) generates a positive or negative potential barrier going from 50 milli-electronvolts to several electronvolts relative to the Fermi level of the layers (4, 6) each forming a conductive element.

3. The method according to any one of claims 1 and 2, **characterized in that** the layers (4, 6) each forming a conductive element have a thickness comprised between 0.5 and 200 nm.

4. The method according to any one of claims 1 to 3, **characterized in that** the piece of information stored in the tunnel junction is red by applying a read voltage whereof the absolute value is lower than the absolute value of the voltage having made it possible to store the piece of information in said junction.
